# EUROPEAN PATENT SPECIFICATION

(11) **EP 0 811 248 B1**
(45) Date of publication and mention of the grant of the patent: **02.05.2002**
(21) Application number: 96906367.6
(22) Date of filing: 09.02.1996
(51) Int. Cl.: H01L 27/108, H01L 21/8242

(54) **DRAM BIT LINE CONTACT AND METHOD OF FORMING SUCH A CONTACT**
DRAM-BITLEITUNGSKONTAKT UND VERFAHREN ZUR HERSTELLUNG EINES SOLCHEN KONTAKTES
CONTACT DE LIGNE DE BIT DE RAM DYNAMIQUE ET PROCEDE POUR FORMER UN TEL CONTACT

(30) Priority: 22.02.1995 US 394545; 22.02.1995 US 394546
(43) Date of publication of application: 10.12.1997
(60) Divisional application: 00203093.0
(73) Proprietor: MICRON TECHNOLOGY, INC., Boise, ID 83706-9632 (US)
(72) Inventor: JOST, Mark, Boise, ID 83712 (US); DENNISON, Charles, H., Meridian, ID 83642 (US); PAREKH, Kunal, Boise, ID 83712 (US)
(74) Representative: Allman, Peter John
(86) International application number: US9601841
(87) International publication number: WO9626544

(56) References cited:
- EP-A- 0 439 965
- PATENT ABSTRACTS OF JAPAN vol. 13, no. 235 (E-766), 30 May 1989 & JP,A,01 041262 (HITACHI LTD), 13 February 1989,
- PATENT ABSTRACTS OF JAPAN vol. 15, no. 241 (E-108), 21 June 1991 & JP,A,03 076159 (SONY CORP), 2 April 1991,
- PATENT ABSTRACTS OF JAPAN vol. 15, no. 170 (E-1062), 30 April 1991 & JP,A,03 038061 (FUJITSU LTD), 19 February 1991,
- PATENT ABSTRACTS OF JAPAN vol. 15, no. 254 (E-108), 27 June 1991 & JP,A,03 082155 (NEC CORP), 8 April 1991,
- PATENT ABSTRACTS OF JAPAN vol. 15, no. 4 (E-1020), 8 January 1991 & JP,A,02 260454 (SONY CORP), 23 October 1990,
- PATENT ABSTRACTS OF JAPAN vol. 16, no. 332 (E-1236), 20 July 1992 & JP,A,04 099375 (MITSUBISHI ELECTRIC CORP), 31 March 1992,

## Description

### Technical Field

This invention relates generally to formation of a bit line over capacitor arrays of memory cells.

### Background Art

As DRAMs increase in memory cell density, there is a continuing challenge to maintain sufficiently high storage capacitance despite decreasing cell area. Additionally, there is a continuing goal to further decrease cell area. The principal way of increasing cell capacitance is through cell structure techniques. Such techniques include three-dimensional cell capacitors, such as trenched or stacked capacitors.

Conventional stacked capacitor DRAM arrays utilize either a buried bit line or a non-buried bit line construction. With buried bit line constructions, bit lines are provided in close vertical proximity to the bit line contacts of the memory cell field effect transistors (FETs), with the cell capacitors being formed horizontally over the top of the word lines and bit lines. With non-buried bit line constructions, deep vertical contacts are made through a thick insulating layer to the cell FETs, with the capacitor constructions being provided over the word lines and beneath the bit lines. Such non-buried bit line constructions are also referred to as "capacitor-under-bit line" or "bit line-over-capacitor" constructions, and are the subject of this invention.

JP-A-01041262 discloses a memory cell having a capacitor formed on the inner wall of a groove, the groove extending through an interlayer insulating film covering a MOS transistor. The capacitor consists of a lower electrode connected to the diffusion layer, a thin dielectric film and an upper electrode. In order to provide a sufficient capacitance, the interlayer insulating film must be made comparatively thickly, increasing the depth of the cell.

### Brief Description of the Drawings

Preferred embodiments of the invention are described below with reference to the following accompanying drawings.

Fig. 1 is a diagrammatic sectional view of a semiconductor wafer fragment at one processing step in accordance with the invention.

Fig. 2. is a view of the Fig. 1 wafer taken at a step subsequent to that shown by Fig. 1.

Fig. 3 is a view of the Fig. 1 wafer taken at a step subsequent to that shown by Fig. 2.

Fig. 4 is a view of the Fig. 1 wafer taken at a step subsequent to that shown by Fig. 3.

Fig. 5 is a view of the Fig. 1 wafer taken at a step subsequent to that shown by Fig. 4.

Fig. 6 is a view of the Fig. 1 wafer taken at a step subsequent to that shown by Fig. 5.

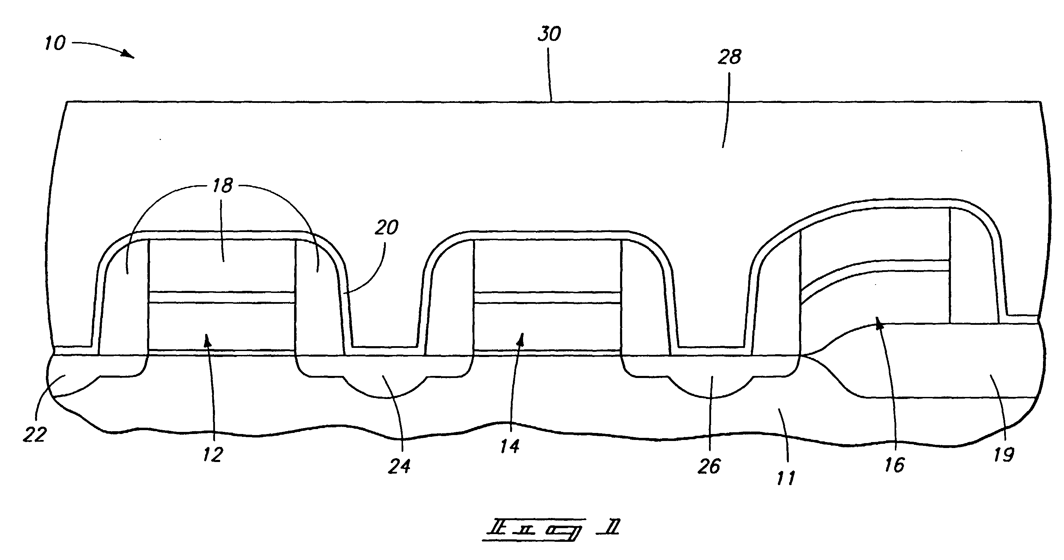

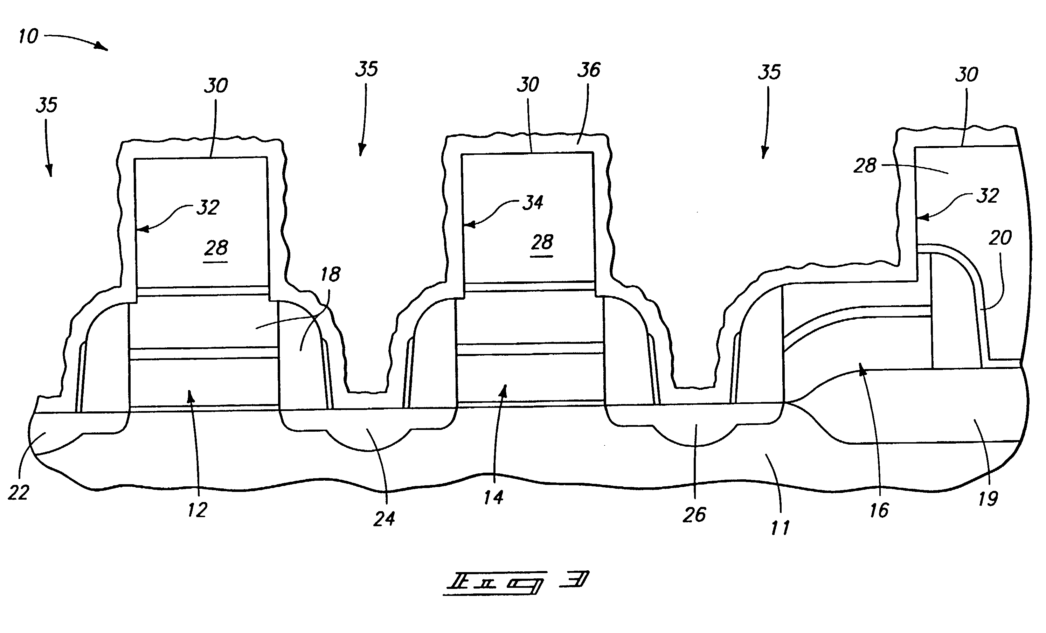

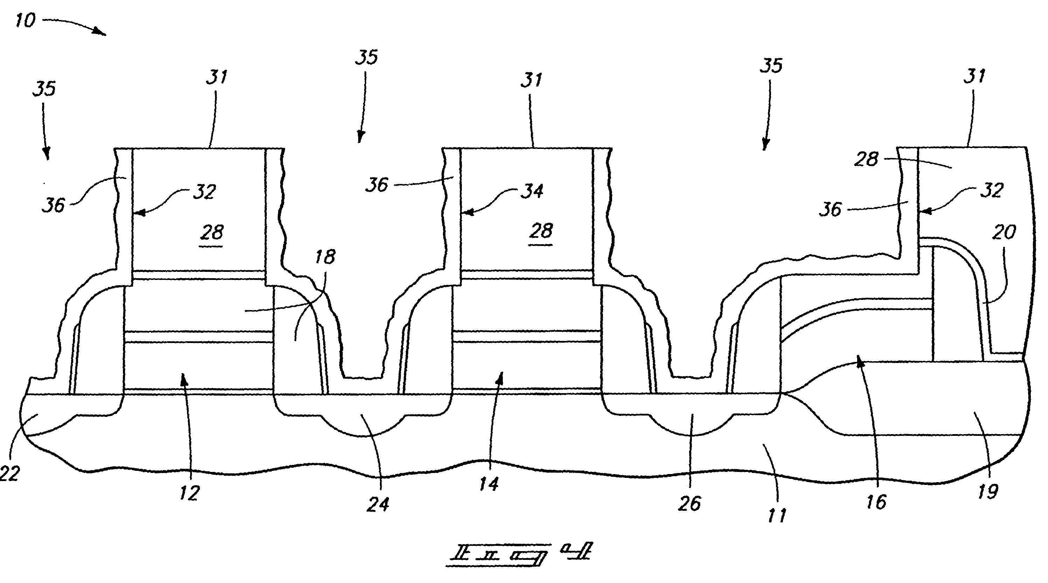

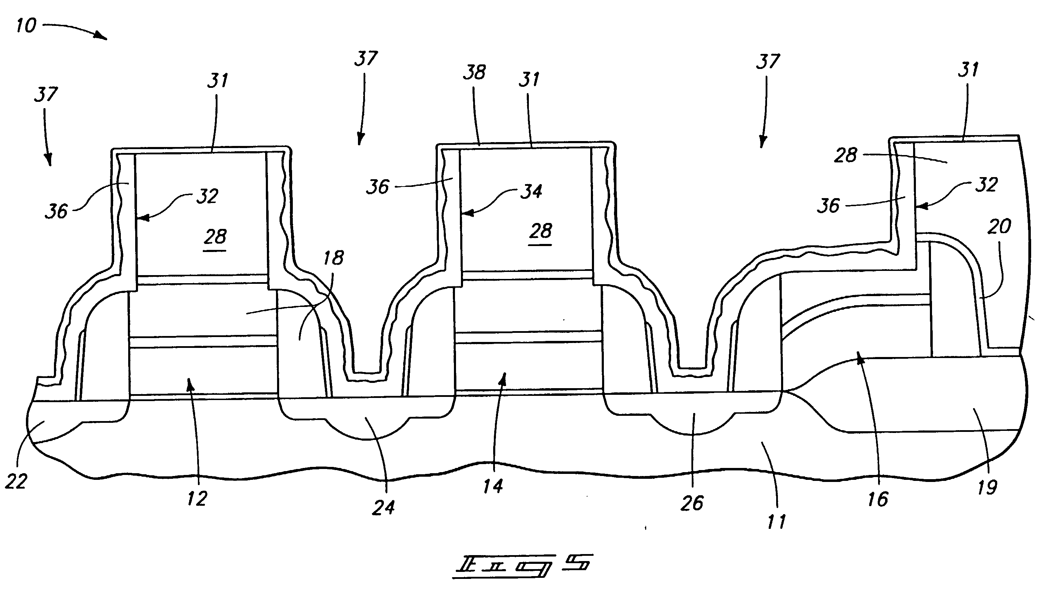

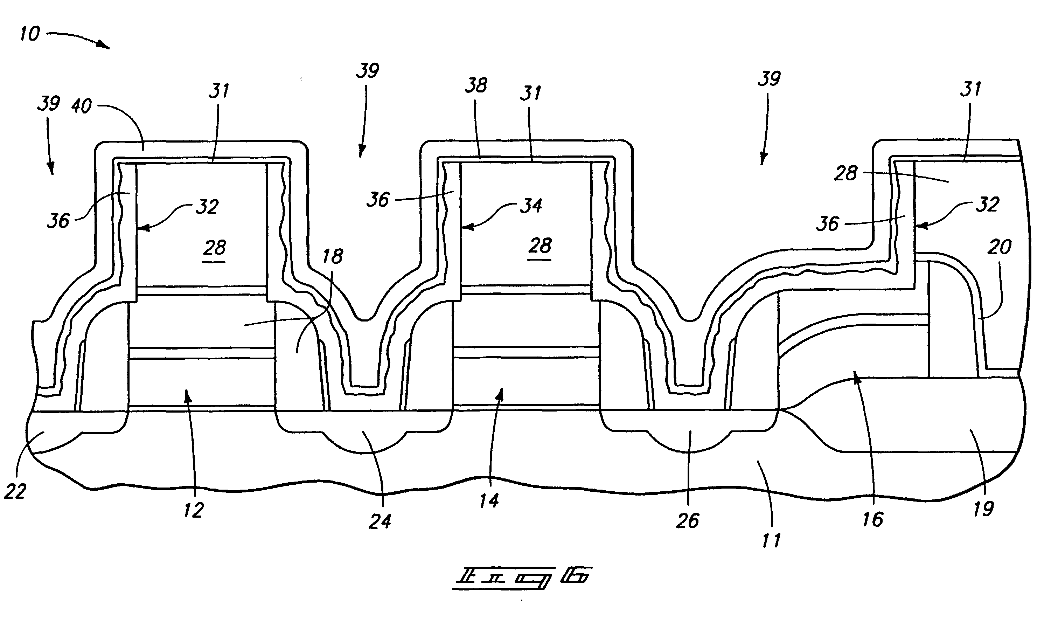

Fig. 5 is a view of the Fig. 1 wafer taken at a step subsequent to that shown by Fig. 6.

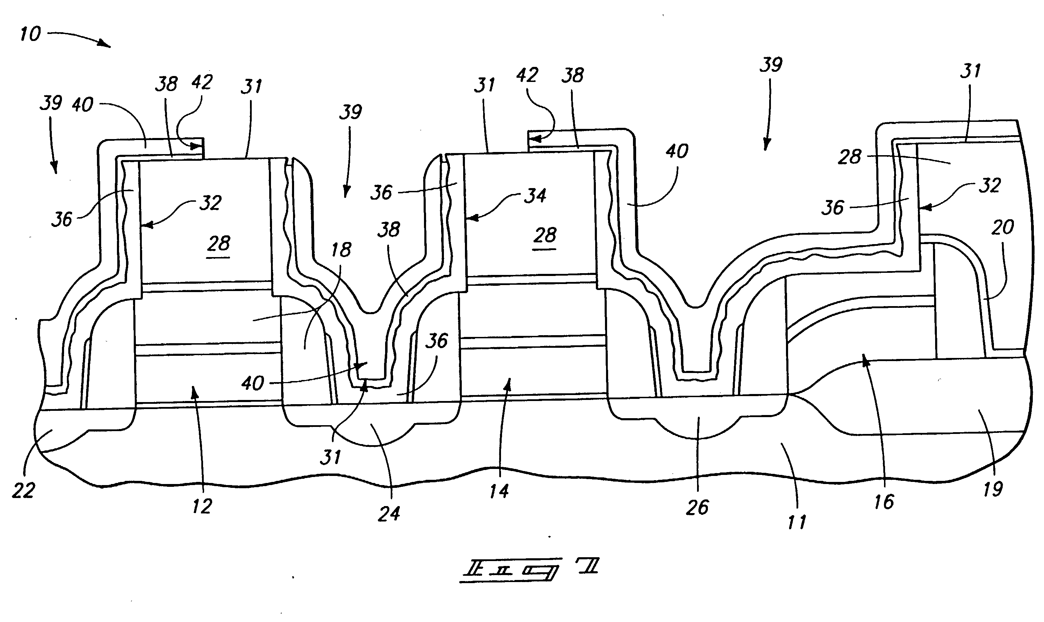

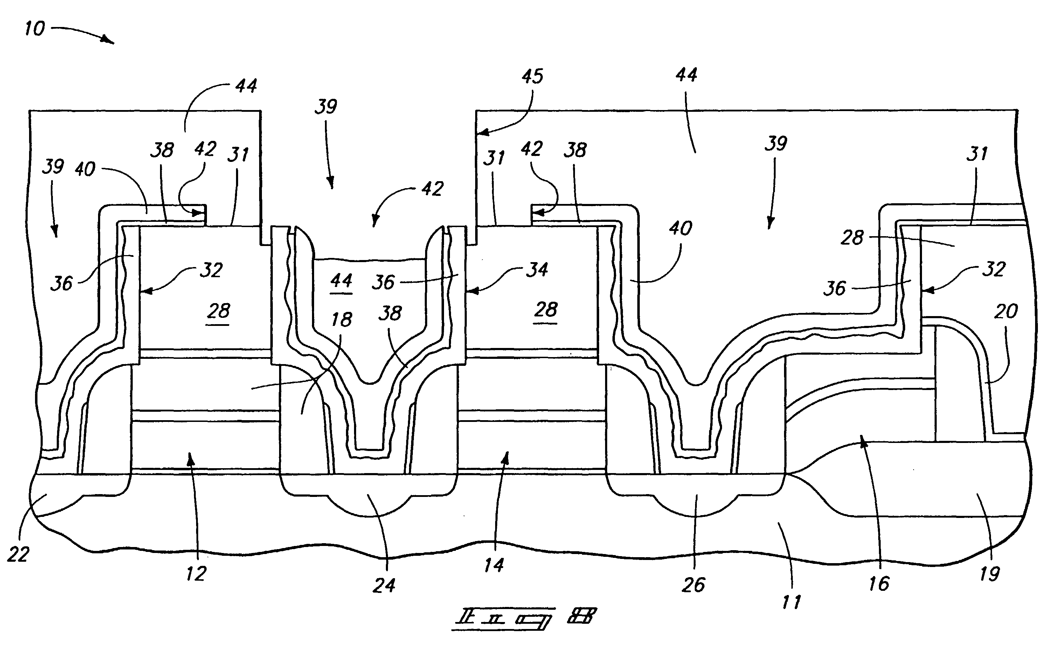

Fig. 8 is a view of the Fig. 1 wafer taken at a step subsequent to that shown by Fig. 7.

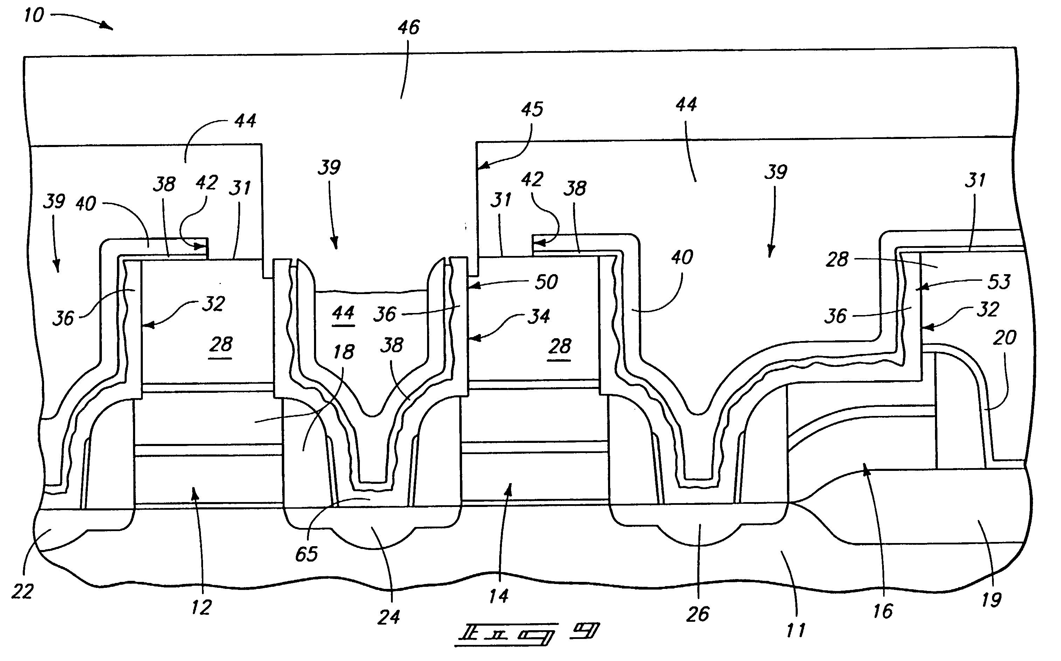

Fig. 9 is a view of the Fig. 1 wafer taken at step subsequent to that shown by Fig. 8.

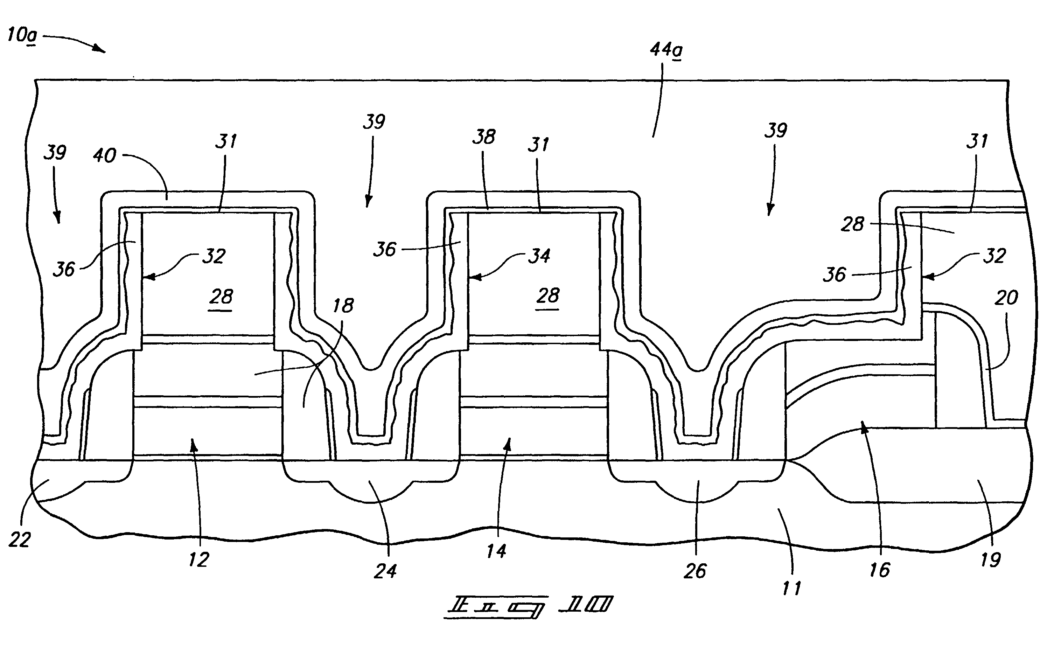

Fig. 10 is a diagrammatic sectional view of an alternate embodiment semiconductor wafer fragment at one alternate processing step in accordance with the invention.

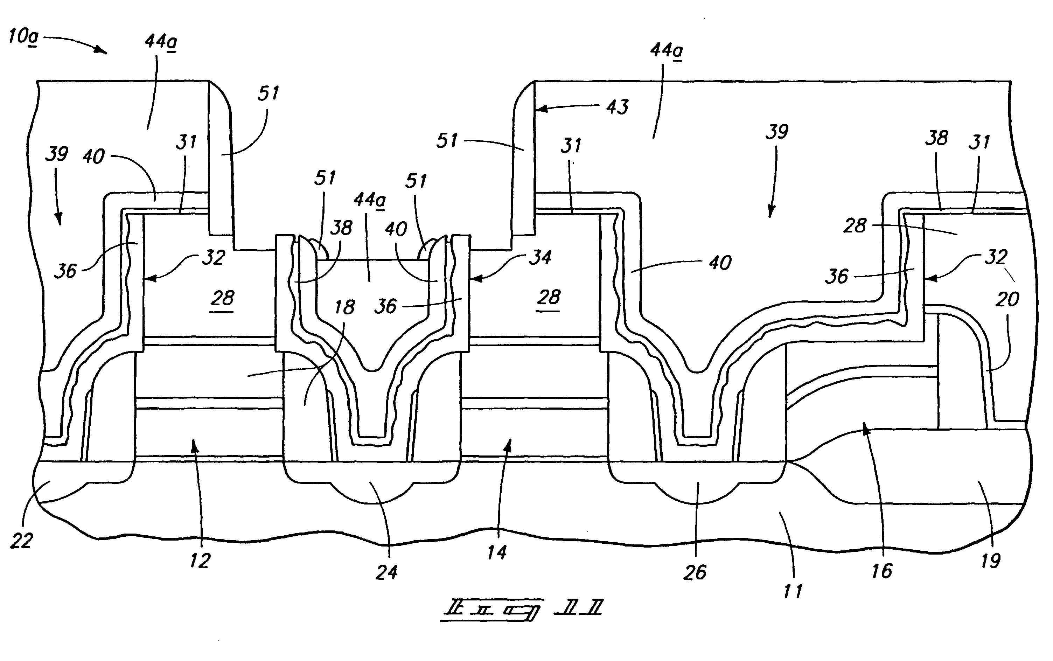

Fig. 11 is a view of the Fig. 10 wafer taken at a step subsequent to that shown by Fig. 10.

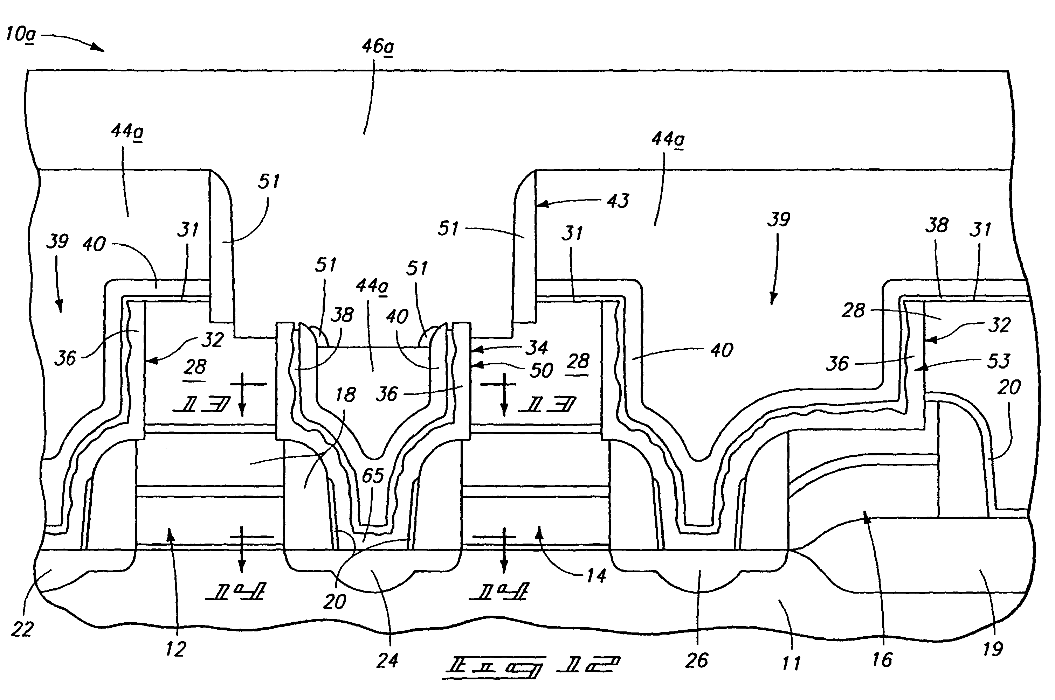

Fig. 12 is a view of the Fig. 10 wafer taken at a step subsequent to that shown by Fig. 11.

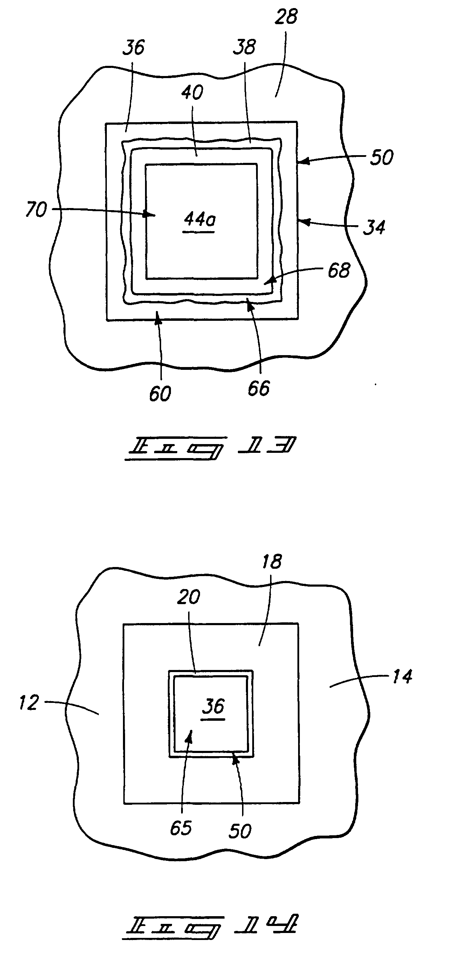

Fig. 13 is a diagrammatic sectional view taken through line 13-13 in Fig. 12.

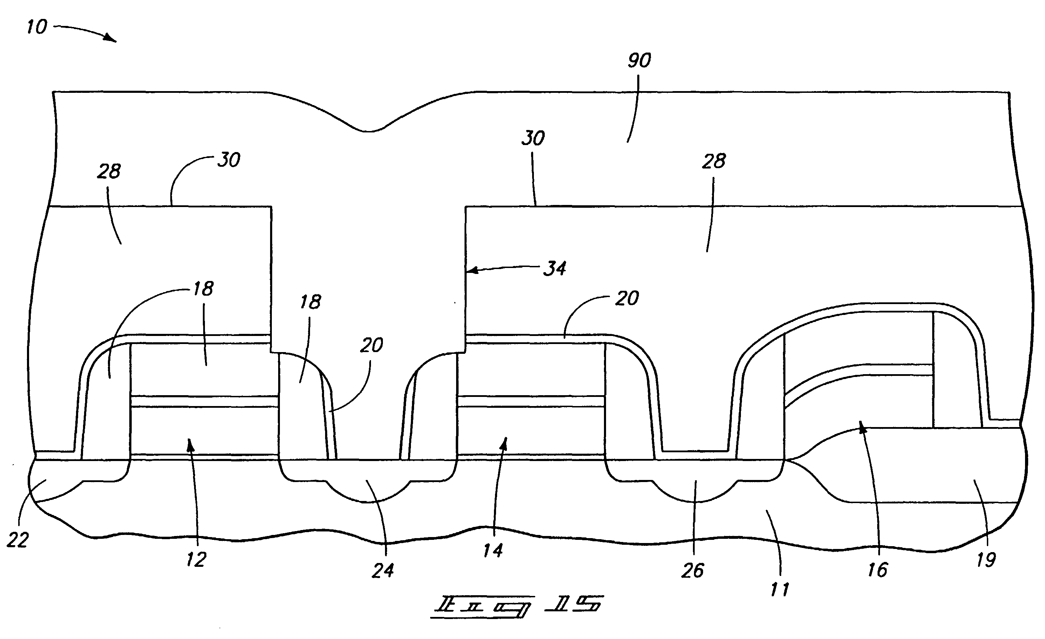

Fig. 14 is a diagrammatic sectional view taken through line 14-14 in Fig. 12.

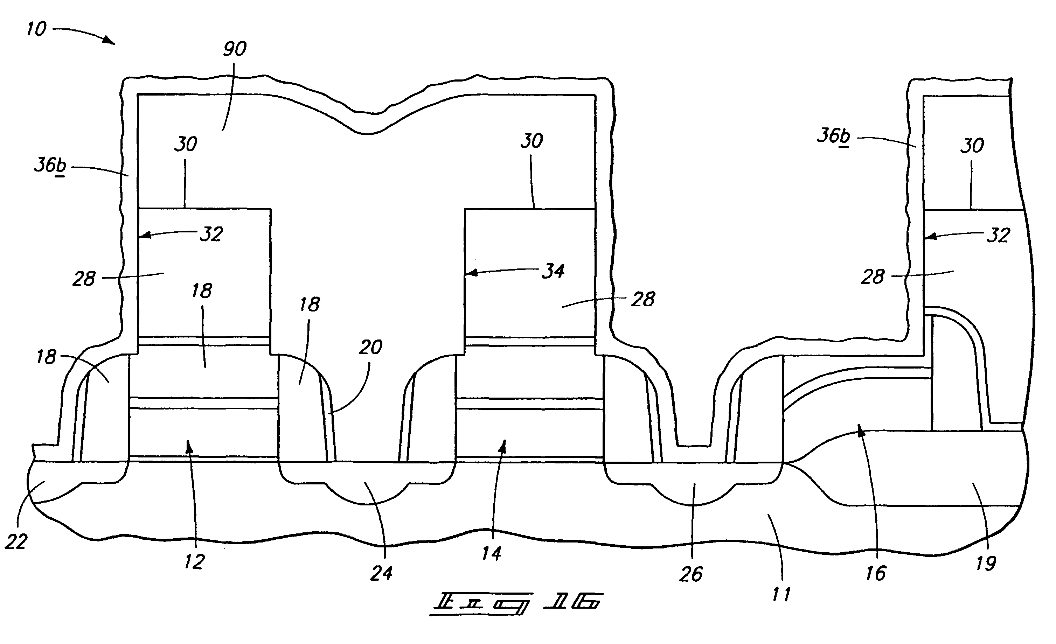

Fig. 15 is a diagrammatic sectional view of a semiconductor wafer fragment at a processing step.

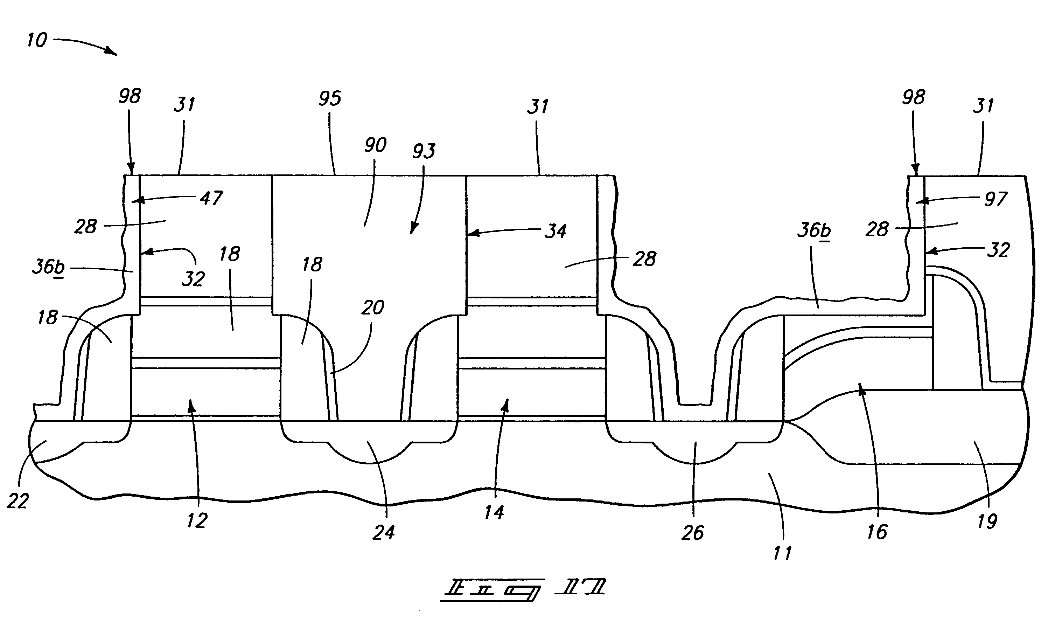

Fig. 16 is a view of the Fig. 15 wafer taken at a step subsequent to that shown by Fig. 15.

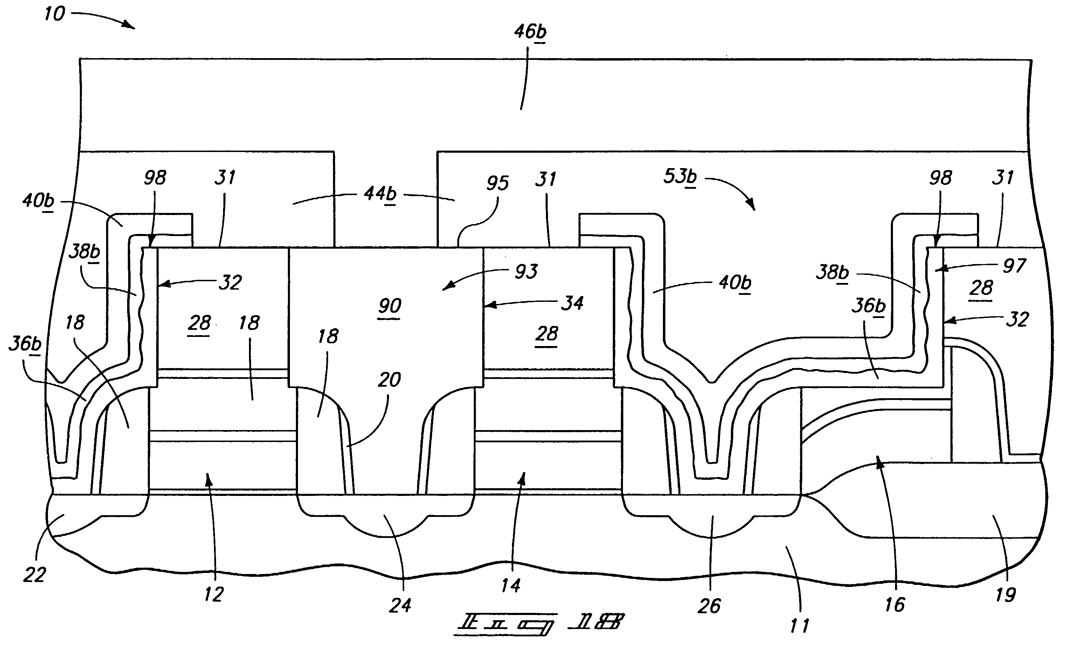

Fig. 17 is a view of the Fig. 15 wafer taken at a step subsequent to that shown by Fig. 16.

Fig. 18 is a view of the Fig. 15 wafer taken at a step subsequent to that shown by Fig. 17.

### Best Modes for Carrying Out the Invention and Disclosure of Invention

In accordance with one aspect of the invention, there is provided a method of forming an interconnecting plug between a first node and second node, the second node being elevationally higher than the first node, the method comprising the following steps:
forming a first layer of electrically conductive material in contact with the first node, the first layer defining a first layer void which opens upwardly;
forming a dielectric layer within the first layer void, the dielectric layer defining a dielectric layer cup which opens upwardly;
characterized by forming a second layer of electrically conductive material within the dielectric layer cup the second layer defining a second layer void which opens upwardly;
forming a non-annular substantially solid mass of insulative material within the second layer void; and
forming the second node in contact with the electrically conductive first layer material.

Preferably, the first node is an active region and the second node is a bit line contact, the method further comprising:
providing an array of substantially electrically isolated word lines atop a semiconductor wafer;
providing active areas about the word lines to define an array of memory cell FETs, the active areas being defined by a first active region for electrical connection with a memory cell capacitor and a second active region for electrical connection with a bit line, the second active area region being the first node;
providing a layer of electrically insulating material over the word lines and active regions, the layer of insulating material having an uppermost surface which is above the word lines;
providing first and second respective contact openings through the insulating material layer to the respective first and second active areas;
providing a first layer of electrically conductive material over the insulating material layer and within the first and second contact openings which electrically connects with the respective first and second active regions, the first layer being provided to a thickness which less than completely fills the first and second contact openings thereby leaving outwardly open first voids within the first and second contact openings;
providing a dielectric layer over the first layer and within the first layer voids of the first and second contact openings, the dielectric layer being provided to a thickness which less than completely fills the first voids thereby leaving outwardly open dielectric layer cups within the first and second contact openings;
providing a second layer of electrically conductive material within the dielectric layer cups of the first and second contact openings;
electrically isolating all electrically conductive material within the first contact openings from all electrically conductive material within the second contact openings;
providing a bit line insulating layer outwardly of the second layer of electrically conductive material;
patterning a bit contact opening through the bit line insulating layer to outwardly expose electrically conductive first layer material within the second contact openings;
forming the bit line contact in the bit contact opening; and
providing a patterned bit line in electrical communication with the outwardly exposed electrically conductive first layer material within the second contact openings through the bit contact opening.

In accordance with a second aspect of the invention, an integrated circuit comprises: an integrated circuit comprising an electrically conductive interconnecting plug electrically connecting between at least two different elevation circuit nodes, the integrated circuit comprising:
a first lower elevation node;
a second higher elevation node; and
an interconnecting plug comprising:
   an outer electrically conductive cup in electrical contact with the first and second nodes;
   characterized by an electrically insulating cup within the outer electrically conductive cup;
   an inner electrically conductive cup within the electrically insulating cup; and
a non-annular substantially solid mass of insulative material within the inner electrically conductive cup.

These and other aspects of the invention will be appreciated from the following description and concluding claims.

Referring first to Fig. 1, a semiconductor wafer fragment is indicated generally by reference numeral 10. Wafer 10 is defined in part by a bulk silicon semiconductive substrate 11, and has been provided with an array of substantially electrically isolated word lines, such as the illustrated word lines 12, 14 and 16. Such word lines are of a conventional construction having a lowermost gate oxide, a lower polysilicon layer, an overlying silicide layer such as tungsten silicide, and insulating caps and side insulating spacers 18. Such spacers and caps 18 preferably comprise an insulative nitride, such as Si₃N₄. A thin layer 20 of Si₃N₄ is provided atop the wafer to function as a diffusion barrier. Layer 20 has a thickness which is preferably from about 10 nm (100 Angstroms) to about 25 nm (250 Angstroms).

Active areas are provided about the word lines, such as active regions 22, 24 and 26, to define an array of memory cell FETs. The discussion proceeds with reference to a FET formed using word line 14, which would be provided with a capacitor construction for definition of a single memory cell. Active region 26 defines a first active region for electrical connection with a memory cell capacitor (described below). Active region 24 defines a second active region for electrical connection with a bit line (described below). Field oxide 19 is provided, as shown.

A first insulating material layer 28 is provided over the word lines and active areas. An example material is borophosphosilicate glass (BPSG), with an example deposition thickness being between 600 and 2,000 nm (6,000 and 20,000 Angstroms). Preferably as shown, layer 28 is subsequently planarized by chemical-mechanical polishing (CMP) to an elevation of from about 200 nm (2,000 Angstroms) to about 800 nm (8,000 Angstroms) above the word line nitride caps 18 which are positioned adjacent the active areas, as opposed to the word lines which are over the field oxide. Such provides a planarized upper surface 30 which is elevationally above the word lines. Alternately, layer 28 could be unpolished at this point in the process.

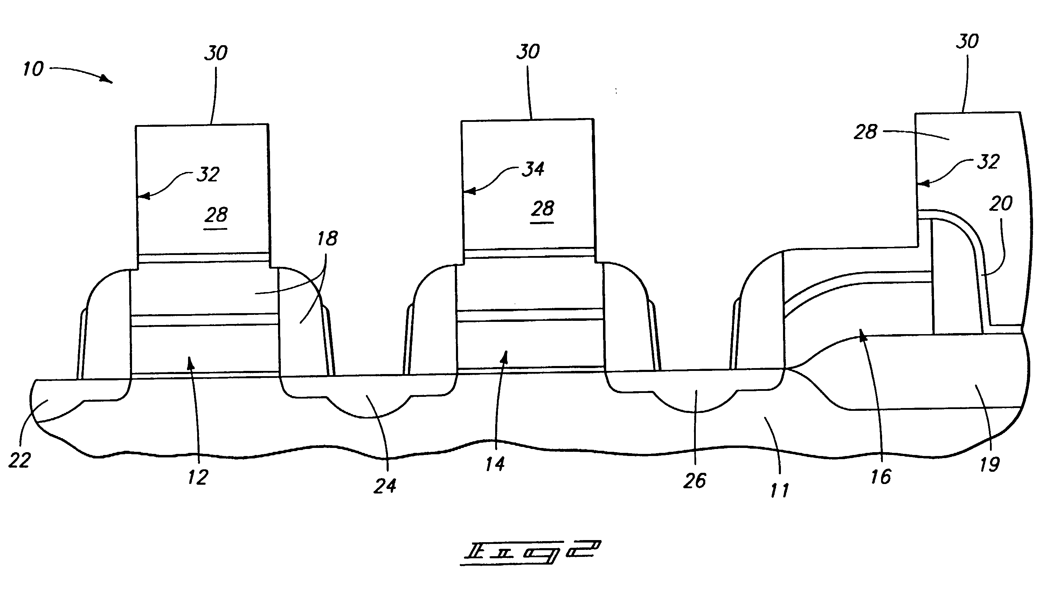

Referring to Fig. 2, a series of first contact openings 32 and second contact openings 34 are provided through first layer 28 to first and second active regions 26 and 24, respectively. Such would typically be formed by photomasking and dry chemical etching of BPSG selectively relative to nitride. An example etch chemistry would include CHF₃ and O₂ at low O₂ flow rate (i.e., less than 5% O₂ by volume in a CHF₃/O₂ mixture), or the combination of CF₄, Ar, CH₂F₂ and CHF₃. Thereafter, an etch of the wafer is conducted to etch nitride layer 20 selectively relative to underlying silicon substrate 11 to upwardly expose active regions 26 and 24. An example etch chemistry would include a combination of CHF₃ and CF₄. The principal purpose of barrier layer 20 is to prevent diffusion of boron or phosphorus atoms from BPSG layer 28 into active areas 24 and 26. Caps 18 are preferably comprised of nitride (Si₃N₄) and layer 28 comprised of oxide, such that the contact etch to produce first contacts 32 and 34 will stop relative to word line spacers and caps 18.

Referring to Fig. 3, a first layer 36 of electrically conductive material is provided over insulating material layer 28 to within first contact opening 32 and second contact opening 34 to electrically connect with first and second active regions 26 and 24, respectively. First layer 36 is deposited to a thickness which less than completely fills first contact opening 32 and second contact opening 34, thereby leaving outwardly open first voids 35 within the first and second contact openings. An example diameter for first contact opening 32 is 0.6 µm (0.6 micron), while example dimensions for second contact opening 34 are 0.6 x 1.0 µm (0.6 x 1.0 micron). In such instance, an example preferred thickness for layer 36 is 100 nm (1000 Angstroms). An example and preferred material for layer 36 is hemispherical grain (HSG) polysilicon. Such can be provided by first depositing a 60 nm (600 Angstroms) thick *in situ* doped polysilicon layer, followed by deposition of undoped HSG poly. Subsequent heating inherent in wafer processing will effectively conductively dope the overlying HSG poly layer. Alternately, layer 36 can be provided by *in situ* arsenic doping of an entire HSG layer.

Referring to Fig. 4, wafer fragment 10 is planarized etched downwardly at least to former upper surface 30 (not shown) of insulating material 28 to remove conductive material 36 thereabove. This will isolate first layer conductive material 36 within first contact openings 32 from first layer conductive material 36 within second contact openings 34. Such planarized etching can be conducted by photoresist deposition and etchback, or by chemical-mechanical polishing. As shown, such planarized etching is conducted to a location which is slightly below former outer insulating layer 30, which in Fig. 4 is now designated with numeral 31.

Referring to Fig. 5, a capacitor dielectric layer 38 is provided over patterned first conductive layer 36 and within first voids 35 of first contact openings 32 and second contact openings 34. Capacitor dielectric layer 38 is provided to a thickness which less than completely fills first voids 35, thereby leaving outwardly open second voids 37 within the first and second contact openings. Layer 38 preferably comprises an oxide-nitride-oxide (ONO) cell dielectric, with an example preferred total deposition thickness being 8 nm (80 Angstroms). Other materials, such as T₂O₅ or barium strontium titanate, are also of course possible. Thus in this preferred described embodiment, the planarized etching step which isolates first conductive material layer 36 relative to the first and second contact openings is conducted prior to the step of providing capacitor dielectric layer 38. layer 90 and within first contact opening 32 to electrically connect with first active region 26. Layer 36b is deposited to a thickness which less than completely fills first contact opening 32. Example dimensions for first contact opening 32 are 0.5 µm (0.5 micron) by 0.8 µm (0.8 micron) while an example diameter for second contact opening 34 is 0.5 µm (0.5 micron). In such instance, an example preferred thickness for layer 90 is 400 nm (4000 Angstrom). An example and preferred material for layer 36b is hemispherical grain (HSG) polysilicon. Such can be provided by first depositing a 60 nm (600 Angstroms) thick *in situ* doped polysilicon layer, followed by deposition of undoped HSG poly. Subsequent heating inherent in wafer processing will effectively conductively dope the overlying HSG poly layer. Alternately, layer 36b can be provided by *in situ* arsenic doping of an entire HSG layer. Layer 36b is provided to physically contact active area 26 without there being any intervening conductive layer.

Referring to Fig. 17, capacitor storage node layer 36b and first conductive layer 90 are chemically mechanically polished inwardly to at least upper surface 30 (shown in Fig. 16) of insulating material layer 28. In the illustrated process, such chemical-mechanical polishing removes first conductive layer 90 and capacitor storage node layer 36b downwardly to below former upper surface 30 of insulating material 28, which is newly designated with numeral 31. In the illustrated process, such polishing is conducted to remove such materials to downwardly below the former upper surface of insulating material 31. The chemical-mechanical polishing can be conducted in a single step. An example of a chemical-mechanical polishing step to achieve the Fig. 17 construction includes using slurry SC25 from Rodel Products Corporation of Newark, DE, diluted with H₂O and KOH. SC25 consists primarily of H₂O, silica (SiO₂ particles), and KOH. It is diluted approximately 1:1 with H₂O and additional KOH can be injected at the point of use to increase the pH and adjust the oxide to silicon etch rate if desired.

The chemical-mechanical polishing step effectively electrically isolates first conductive layer material 90 within second contact opening 34 from storage node conductive layer material 36b within first contact opening 32. The chemical-mechanical polishing step also effectively defines a homogenous second contact plug 93 having a plug upper surface 95. Also, the chemical-mechanical polishing step effectively defines an isolated capacitor storage node 97 having an upper surface 98, with upper surface 98 of the storage node being elevationally

Referring to Fig. 6, a second layer 40 of electrically conductive material (preferably polysilicon) is provided within second voids 37 of the first and second contact openings to a thickness which less than completely fills the voids, thereby leaving outwardly open third voids 39 within the first and second contact openings.

Referring to Fig. 7, cell polysilicon layer 40 and underlying cell dielectric layer 38 are patterned and etched to define the desired configuration of cell poly layer 40 for capacitor and interconnecting line construction, and to outwardly expose first electrically conductive material layer 36 within second contact opening 34. This effectively defines a contact opening 42 which is larger than and encapsulates all of second contact opening 34. Thus, all electrically conductive material within first contact openings 32 is electrically isolated from ohmic contact from all electrically conducted material within second contact openings 34. The Fig. 7 etch is conducted to etch polysilicon selectively relative to oxide initially, followed by etching of the oxide/nitride oxide selectively relative to polysilicon. Modification of the upper profile of layers 36, 38 and 40 at the top of second contact opening 34 will be produced as shown.

Referring to Fig. 8, a bit line insulating layer 44 (e.g., BPSG) is provided outwardly of second electrically conductive material layer 40 and to within third voids 39. A bit contact opening 45 is patterned through bit line insulating layer 40 to again outwardly expose electrically conductive first layer material 36 within second contact opening 34.

Referring to Fig. 9, a patterned bit line 46 is provided in electrical communication with the outwardly exposed electrically conductive first material layer 36 within second contact opening 34 through bit contact opening 45.

The above described process etches capacitor dielectric layer 38 and second conductive layer 40 away from over second contact opening 34 prior to provision of bit line insulating layer 44. An alternate process wherein such etching is conducted after provision of bit line insulating layer 44 is described with reference to Figs. 10-14. Fig. 10 illustrates the Fig. 6 wafer at a processing step immediately subsequent to Fig. 6 which differs from that shown in Fig. 7. Like numbers are utilized from the first described embodiment where appropriate, with significant differences being indicated by addition of a suffix "a" to the Figs. 10-14 embodiment. Fig. 10 shows fragment 10a having bit line insulating layer 44a deposited atop previously un-patterned layers 40 and 38.

Referring to Fig. 11, layer 44a is patterned and etched to provide a bit contact opening 43 over plugged second contact opening 34. A dielectric film is deposited and anisotropically etched to provide sidewall spacers 51. Referring to Figs. 12-14, a patterned bit line layer 46a is provided. Spacers 51 electrically isolate film 40 within contact opening 32 from film 46a within bit contact opening 43.

The Figs. 10-14 process in comparison with the first described embodiment, while having the advantage of reduced masking steps, does have the disadvantage of providing greater parasitic capacitance between the bit line plugging material within contact opening 43 the result of closer proximity of such material to second cell poly layer 40 than in the first described embodiment.

Regardless of the above techniques, the process results in definition of a bit line plug 50 (Figs. 9, 12 and 13) within second contact opening 34, and a novel semiconductor memory device. Such is comprised, by way of example, of field effect transistor gate 14 and opposing active areas 24 and 26 (Figs. 9 and 12). A capacitor 53 electrically connects with the one active area 26. A bit line 46/46a electrically connects with the other active area 24 through bit line plug 50, which extends through intermediate dielectric insulating layer 44/44a. Referring principally to Fig. 13, bit plug 50 comprises an electrically conductive annular ring 60 which is defined or formed of conductive material layer 36 within second contact opening 34. Bit line plug 50 comprises a non-annular solid mass bass plug 65 (Figs. 9, 12 and 14) which electrically connects with active area 24. Electrically conductive annular ring 60 is integral with and extends outwardly of base plug 65 the result of both constituting or resulting from conductive layer 36 deposition.

Layer 38 material comprises an electrically insulating annular ring 66 (Fig. 13) which is positioned radially inward of electrically conductive annular ring 60. Likewise, layer 40 comprises an inner electrically conductive annular ring 68 (Fig. 13) positioned radially inward of electrically insulating annular ring 66. Finally, material 44a comprises a non-annular substantially solid mass inner electrically insulating plug 70 (Fig. 13) which is provided radially inward of inner electrically conductive annular ring 68.

Accordingly in the above-described preferred embodiments, electrically conductive annular ring 60 is that portion of bit plug 50 which effectively provides electrical communication between active area 24 and bit line 46/46a. Conductive material 40 of inner electrically conductive annular ring 68 is isolated from ohmic electric connection with ring 60 the result of intervening dielectric layer 38. Despite the reduced contact area at the outer portion of a bit line plug, resistive loss of the poly has been calculated to be less than 600 ohms.

Although the immediately above-described construction was relative to a semiconductor memory device, aspects of the invention are believed to have application to other integrated circuit art areas having active areas formed relative to a semiconductor substrate where electrical connection is desired to an elevationally higher electrically conductive line. Aspects of the construction are also believed to be applicable to other integrated circuitry where elevationally inner and outer discrete electrically conductive nodes are desired to be interconnected in ohmic electrical connection.

The above described processes fill both the first contact openings 32 and the second contact openings 34 with layers of conductive material and dielectric material. An alternate process wherein the first contact openings are filled with layers of conductive material and dielectric material and wherein the second contact openings are filled with only a conductive layer is described with reference to Figs. 15-18. Fig. 15 illustrates the Fig. 1 wafer at a processing step immediately subsequent to Fig. 1 which differs from that shown in Fig. 2. Like numbers are utilized from the previous described embodiments where appropriate, with significant differences being indicated by addition of a suffix "b" to the Figs. 15-18 process.

Referring to Fig. 15, a series of second contact openings 34 is provided through insulating material layer 28 inwardly to outwardly expose second active region 24. Such would typically be formed, as described above, by photomasking and dry chemical etching of BPSG selectively relative to nitride and thereafter by etching nitride layer 20 selectively relative to underlying silicon substrate 11.

Subsequently, an electrically conductive layer 90 is provided over insulating material layer 28, upper surface 30 and within second contact opening 34 to electrically connect with second active region 24. Conductive layer 90 is deposited to a thickness sufficient to completely fill second contact opening 34, as shown. An example preferred composition for the material of layer 90 is conductively doped polysilicon.

Referring to Fig. 16, a series of first contact openings 32 is provided through electrically conductive layer 90 and insulating material layer 28 inwardly to outwardly expose first active region 26. Subsequently, a capacitor storage node electrically conductive layer 36b is provided over first electrically conductive coincident with upper surface 95 of plug 93, and correspondingly with upper surface 31 of insulating material layer 28.

Referring to Fig. 18, an ONO cell dielectric layer 38b and overlying outer second layer of conductive material 40b are provided to provide a capacitor construction 53b. As shown, capacitor construction 53b includes an inner storage node 36b, a capacitor dielectric layer 38b and outer cell node 40b. An overlying insulating layer 44b is then provided, followed by subsequent deposition and patterning of a conductive material to form a bit line 46b. A homogenous electrically conductive bit line plug is thereby provided between active area 24 and the elevation of planarized surface 31, and therefore between active area 24 and the elevation of inner storage node 97 upper surface 98.

## Claims

1. A method of forming an interconnecting plug between a first node (24) and second node (46), the second node (46) being elevationally higher than the first node (24), the method comprising the following steps:
forming a first layer (36) of electrically conductive material in contact with the first node (24), the first layer defining a first layer void (35) which opens upwardly;
forming a dielectric layer (31) within the first layer void, the dielectric layer defining a dielectric layer cup (37) which opens upwardly;
**characterized by** forming a second layer (40) of electrically conductive material within the dielectric layer cup, the second layer defining a second layer void (39) which opens upwardly;
forming a non-annular substantially solid mass (44) of insulative material within the second layer void (39); and
forming the second node (46) in contact with the electrically conductive first layer material (36).

2. The method of claim 1, wherein the second node (46) is in contact with the non-annular substantially solid mass (44).

3. The method of claim 1 or claim 2, wherein the second node (46) is comprised by a bit line contact, and wherein the bit line contact is in contact with the second layer of electrically conductive material.

4. The method of claim 1, wherein the first node is an active area and the second node is a bit line contact, comprising:
forming a layer of electrically insulating material (18) over the active area;
forming a contact opening (32, 34) in the insulating material layer to the active area;
forming the first layer (36) of electrically conductive material within the contact opening;
forming the dielectric layer (38) over the first layer to define the dielectric layer cup within the contact opening;
forming the second layer (40) of electrically conductive material within the dielectric layer void, to define the second layer void within the contact opening; and
forming a patterned bit line (46) in electrical contact with the electrically conductive first layer material within the contact opening through the bit line contact.

5. The method of claim 4 further comprising planarize etching the first conductive material layer downwardly to at least the upper surface (31) of the insulating material layer.

6. The method of claim 1, wherein the first node is an active region and the second node is a bit line contact, further comprising:
providing an array of substantially electrically isolated word lines (12, 14, 16) atop a semiconductor wafer;
providing active areas about the word lines to define an array of memory cell FETs, the active areas being defined by a first active region for electrical connection with a memory cell capacitor and a second active region for electrical connection with a bit line, the second active area region being the first node;
providing a layer of electrically insulating material (18) over the word lines and active regions, the layer of insulating material having an uppermost surface which is above the word lines;
providing first (32) and second (34) respective contact openings through the insulating material layer to the respective first (26) and second (24) active areas;
providing a first layer of electrically conductive material (36) over the insulating material layer and within the first and second contact openings which electrically connects with the respective first and second active regions, the first layer being provided to a thickness which less than completely fills the first and second contact openings thereby leaving outwardly open first voids within the first and second contact openings;
providing a dielectric layer over the first layer and within the first layer voids of the first and second contact openings, the dielectric layer being provided to a thickness which less than completely fills the first voids thereby leaving outwardly open dielectric layer cups within the first and second contact openings;
providing a second layer (40) of electrically conductive material within the dielectric layer voids of the first and second contact openings;
electrically isolating all electrically conductive material within the first contact openings from all electrically conductive material within the second contact openings;
providing a bit line insulating layer (44) outwardly of the second layer of electrically conductive material;
patterning a bit contact opening (45) through the bit line insulating layer (44) to outwardly expose electrically conductive first layer material within the second contact openings;
forming the bit line contact in the bit contact opening; and
providing a patterned bit line (46) in electrical contact with the outwardly exposed electrically conductive first layer material within the second contact openings through the bit contact opening.

7. The method of claim 6, wherein the step of electrically isolating comprises planarize etching the first conductive material layer downwardly to at least the upper surface of the insulating material layer to isolate the first conductive material layer within the first contact openings from the conductive material within the second contact openings, such planarize etching being conducted prior to the step of providing the capacitor dielectric layer.

8. The method of claim 1, wherein the first node is an active region (24) and the second node is a bit line contact, further comprising:
forming an array of substantially electrically isolated word lines (12, 14, 16) atop a semiconductor wafer;
forming active areas (24, 26) about the word lines, the active areas being defined by a first active region (26) and a second active region (24), the second active region (24) being the first node;
forming a layer (18) of electrically insulating material over the word lines and active regions;
forming first (32) and second (34) respective contact openings through the insulating material layer to the respective first and second active areas;
forming the first layer (36) of electrically conductive material over the insulating material layer and within the first and second contact openings to electrically connect with the respective first and second active regions, the first layer being provided to a thickness which less than completely fills the first and second contact openings, the first layer leaving outwardly open first layer voids within the first and second contact openings;
forming the dielectric layer over the first layer and within the first voids of the first and second contact openings, the dielectric layer being provided to a thickness which less than completely fills the first layer voids thereby leaving outwardly open dielectric layer cups within the first and second contact openings;
forming the second electrically conductive material within the dielectic layer cups of the first and second contact openings; and
forming a patterned bit line in electrical communication with the conductive first layer material within the second contact openings through the bit line contact.

9. The method of claim 8, further comprising electrically isolating all electrically conductive material within the first contact openings from all electrically conductive material within the second contact openings.

10. The method of claim 8, further comprising:
electrically isolating all electrically conductive material within the first contact openings from all electrically conductive material within the second contact openings;
forming a bit line insulating layer outwardly of the second layer of electrically conductive material; and
patterning a bit contact opening through the bit line insulating layer to outwardly expose electrically conductive first layer material within the second contact openings.

11. An integrated circuit comprising an electrically conductive interconnecting plug electrically connecting between at least two different elevation circuit nodes, the integrated circuit comprising:
a first lower elevation node (24);
a second higher elevation node (46); and
an interconnecting plug comprising:
an outer electrically conductive cup (36) in electrical contact with the first and second nodes;
an electrically insulating cup (38) within the outer electrically conductive cup;
**characterized by**:
an inner electrically conductive cup (40) within the electrically insulating cup; and
a non-annular substantially solid mass (44) of insulative material within the inner electrically conductive cup.

## Patentansprüche

1. Verfahren zum Bilden eines Verbindungspfropfens zwischen einem ersten Knoten (24) und einem zweiten Knoten (46), wobei der zweite Konten (46) in der Höhe höher als der erste Knoten (24) ist, wobei das Verfahren die folgenden Schritte umfasst:
Bilden einer ersten Schicht (36) aus einem elektrisch leitenden Material in Kontakt mit dem ersten Knoten (24), wobei die erste Schicht eine erste Schichtlücke (35) definiert, die sich nach oben hin öffnet;
Bilden einer dielektrischen Schicht (31) innerhalb der ersten Schichtlücke, wobei die dielektrische Schicht eine dielektrische Schichtschale (37) definiert, die sich nach oben hin öffnet;
**gekennzeichnet durch** ein Bilden einer zweiten Schicht (40) aus einem elektrisch leitenden Material innerhalb der ersten Schichtschale, wobei die zweite Schicht eine zweite Schichtlücke (39) definiert, die sich nach oben hin öffnet;
Bilden einer nicht-ringförmigen, im Wesentlichen festen Masse (44) aus einem isolierenden Material innerhalb der zweiten Schichtlücke (39); und
Bilden des zweiten Knotens (46) in Kontakt mit dem elektrisch leitenden ersten Schichtmaterial (36).

2. Verfahren nach Anspruch 1, wobei der zweite Knoten (46) in Kontakt mit der nicht-ringförmigen, im Wesentlichen festen Masse (44) ist.

3. Verfahren nach Anspruch 1 oder Anspruch 2, wobei der zweite Knoten (46) einen Bitleitungskontakt umfasst, und wobei der Bitleitungskontakt in Kontakt mit der zweiten Schicht aus dem elektrisch leitenden Material ist.

4. Verfahren nach Anspruch 1, wobei der erste Knoten in einem aktiven Gebiet ist, und der zweite Knoten ein Bitleitungskontakt ist, umfassend:
Bilden einer Schicht aus einem elektrisch isolierenden Material (18) über dem aktiven Gebiet;
Bilden einer Kontaktöffnung (32, 34) in der isolierenden Materialschicht zu dem aktiven Gebiet;
Bilden der ersten Schicht (36) aus einem elektrisch leitenden Material innerhalb der Kontaktöffnung;
Bilden der dielektrischen Schicht (38) über der ersten Schicht zum Definieren der dielektrischen Schichtschale innerhalb der Kontaktöffnung;
Bilden der zweiten Schicht (40) aus einem elektrisch leitenden Material innerhalb der dielektrischen Schichtlücke, um die zweite Schichtlücke innerhalb der Kontaktöffnung zu definieren;
Bilden einer strukturierten Bitleitung (46) in einem elektrischen Kontakt mit dem elektrisch leitenden ersten Schichtmaterial innerhalb der Kontaktöffnung durch den Bitleitungskontakt.

5. Verfahren nach Anspruch 4, ferner umfassend ein Planarisierungsätzen der ersten leitenden Materialschicht nach unten wenigstens bis zu der oberen Oberfläche (31) der isolierenden Materialschicht.

6. Verfahren nach Anspruch 1, wobei der erste Knoten ein aktiver Bereich ist, und der zweite Knoten ein Bitleitungskontakt ist, ferner umfassend die folgenden Schritte:
Bereitstellen eines Felds von im Wesentlichen elektrisch isolierten Wortleitungen (12, 14, 16) oben auf einem Halbleiterwafer;
Bereitstellen von aktiven Gebieten bei den Wortleitungen zum Definieren eines Felds von Speicherzellen-FETs, wobei die aktiven Gebiete durch einen ersten aktiven Bereich für eine elektrische Verbindung mit einem Speicherzellenkondensator und einem zweiten aktiven Bereich für eine elektrische Verbindung mit einer Bitleitung definiert werden, wobei der zweite aktive Gebietsbereich der erste Knoten ist;
Bereitstellen einer Schicht aus einem elektrisch isolierenden Material (18) über den Wortleitungen und akiven Bereichen, wobei die Schicht aus einem isolierenden Material eine oberste Oberfläche aufweist, die über den Wortleitungen ist;
Bereitstellen von ersten (32) und zweiten (34) jeweiligen Kontaktöffnungen durch die isolierende Materialschicht zu den jeweiligen ersten (26) und zweiten (24) aktiven Gebieten;
Bereitstellen einer ersten Schicht aus einem elektrisch leitenden Material (36) über der isolierenden Materialschicht und innerhalb der ersten und zweiten Kontaktöffnungen, die mit den jeweiligen ersten und zweiten aktiven Bereichen elektrisch in Verbindung steht, wobei die erste Schicht auf eine Dicke bereitgestellt wird, die die ersten und zweiten Kontaktöffnungen weniger als vollständig füllt, wodurch nach außen offene erste Lücken innerhalb der ersten und zweiten Kontaktöffnungen gelassen werden;
Bereitstellen einer dielektrischen Schicht über der ersten Schicht und innerhalb der ersten Schichtlücken der ersten und zweiten Kontaktöffnungen, wobei die dielektrische Schicht mit einer Dicke bereitgestellt wird, die die ersten Lücken weniger als vollständig füllt, wodurch nach außen offene dielektrische Schichtschalen innerhalb der ersten und zweiten Kontaktöffnungen gelassen werden;
Bereitstellen einer zweiten Schicht (40) aus einem elektrisch leitenden Material innerhalb der dielektrischen Schichtlücken der ersten und zweiten Kontaktöffnungen;
Elektrisches Isolieren von sämtlichem elektrisch leitenden Material innerhalb der ersten Kontaktöffnungen von sämtlichem elektrisch leitenden Material innerhalb der zweiten Kontaktöffnungen;
Bereitstellen einer Bitleitungs-Isolationsschicht (44) außerhalb der zweiten Schicht aus dem elektrisch leitenden Material;
Strukturieren einer Bitkontaktöffnung (45) durch die Bitleitungs-Isolationsschicht (44), um nach außen elektrisch leitendes erstes Schichtmaterial innerhalb der zweiten Kontaktöffnungen freizulegen;
Bilden des Bitleitungskontakts in der Bitkontaktöffnung; und
Bereitstellen einer strukturierten Bitleitung (46) in einem elektrischen Kontakt mit dem nach außen freigelegten elektrisch leitenden ersten Schichtmaterial innerhalb der zweiten Kontaktöffnungen durch die Bitkontaktöffnung.

7. Verfahren nach Anspruch 6, wobei der Schritt zum elektrischen Isolieren ein Planarisierungsätzen der ersten leitenden Materialschicht nach unten wenigstens bis zu der oberen Oberfläche der isolierenden Materialschicht, um die erste leitende Materialschicht innerhalb der ersten Kontaktöffnungen von dem leitenden Material innerhalb der zweiten Kontaktöffnungen zu isolieren, wobei ein derartiges Planarisierungsätzen vor dem Schritt zum Bereitstellen der Kondensatordielektrikumschicht ausgeführt wird, umfasst.

8. Verfahren nach Anspruch 1, wobei der erste Knoten ein aktiver Bereich (24) ist und der zweite Knoten ein Bitleitungskontakt ist, ferner umfassend die folgenden Schritte:
Bilden eines Felds von im Wesentlichen elektrisch isolierten Wortleitungen (12, 14, 16) oben auf einem Halbleiterwafer;
Bilden von aktiven Gebieten (24, 26) bei den Wortleitungen, wobei die aktiven Gebiete durch einen ersten aktiven Bereich (26) und einen zweiten aktiven Bereich (24) definiert werden, wobei der zweite aktive Bereich (24) der erste Knoten ist;
Bilden einer Schicht (18) aus einem elektrisch isolierenden Material über den Wortleitungen und aktiven Bereichen;
Bilden von ersten (32) und zweiten (34) jeweiligen Kontaktöffnungen durch die isolierende Materialschicht zu den jeweiligen ersten und zweiten aktiven Gebieten;
Bilden der ersten Schicht (36) aus dem elektrisch leitenden Material über der isolierenden Materialschicht und innerhalb der ersten und zweiten Kontaktöffnungen, um eine elektrische Verbindung mit den jeweiligen ersten und zweiten aktiven Bereichen herzustellen, wobei die erste Schicht auf eine Dicke bereitgestellt wird, die die ersten und zweiten Kontaktöffnungen weniger als vollständig füllt, wobei die erste Schicht nach außen offene erste Schichtlücken innerhalb der ersten und zweiten Kontaktöffnungen lässt;
Bilden der dielektrischen Schicht über der ersten Schicht und innerhalb der ersten Lücken der ersten und zweiten Kontaktöffnungen, wobei die dielektrische Schicht auf eine Dicke bereitgestellt wird, die die ersten Lücken weniger als vollständig füllt, wodurch nach außen offene dielektrische Schichtschalen innerhalb der ersten und zweiten Kontaktöffnungen gelassen werden;
Bilden des zweiten elektrisch leitenden Materials innerhalb der dielektrischen Schichtschalen der ersten und zweiten Kontaktöffnungen; und
Bilden einer strukturierten Bitleitung in einer elektrischen Kommunikation mit dem leitenden ersten Schichtmaterial innerhalb der zweiten Kontaktöffnungen durch den Bitleitungskontakt.

9. Verfahren nach Anspruch 8, ferner umfassend ein elektrisches Isolieren von sämtlichem elektrisch leitenden Material innerhalb der ersten Kontaktöffnungen von sämtlichem elektrisch leitenden Material innerhalb der zweiten Kontaktöffnungen.

10. Verfahren nach Anspruch 8, ferner umfassend die folgenden Schritte:
elektrisches Isolieren von sämtlichem elektrisch leitenden Material innerhalb der ersten Kontaktöffnungen von sämtlichem elektrisch leitenden Material innerhalb der zweiten Kontaktöffnungen;
Bilden einer Bitleitungs-Isolationsschicht außerhalb der zweiten Schicht aus dem elektrisch leitenden Material; und
Strukturieren einer Bitkontaktöffnung durch die Bitleitungs-Isolationsschicht, um elektrisch leitendes erstes Schichtmaterial innerhalb der zweiten Kontaktöffnungen nach außen freizulegen.

11. Integrierte Schaltung, umfassend einen elektrisch leitenden Verbindungspfropfen, der wenigstens zwei Schaltungsknoten in unterschiedlicher Höhe elektrisch verbindet, wobei die integrierte Schaltung umfasst:
einen ersten Knoten (24) auf einer unteren Höhe;
einen zweiten Knoten (46) auf einer höheren Höhe; und
einen Verbindungspfropfen, der umfasst:
eine äußere elektrisch leitende Schale (36) in einem elektrischen Kontakt mit den ersten und zweiten Knoten;
eine elektrisch isolierende Schale (38) innerhalb der äußeren elektrisch leitenden Schale;
**gekennzeichnet durch**:
eine innere elektrisch leitende Schale (40) innerhalb der elektrisch isolierenden Schale; und
eine nicht-ringförmige, im Wesentlichen feste Masse (44) aus einem isolierenden Material innerhalb der inneren elektrisch leitenden Schale.

## Revendications

1. Un procédé de formation d'un bouchon d'interconnexion entre un premier noeud (24) et un second noeud (46), le second noeud (46) étant à un niveau plus élevé que le premier noeud (24), le procédé comprenant les étapes suivantes :
on forme une première couche (36) d'un matériau électriquement conducteur en contact avec le premier noeud (24), la première couche définissant un vide (35) de la première couche qui s'ouvre vers le haut;
on forme une couche diélectrique (31) à l'intérieur vide de la première couche, la couche diélectrique définissant une cuvette de couche diélectrique (37) qui s'ouvre vers le haut;
**caractérisé en ce qu'**on forme une seconde couche (40) de matériau électriquement conducteur à l'intérieur de la cuvette de couche diélectrique, la seconde couche définissant un vide (39) de la seconds couche qui s'ouvre vers le haut;
on forme une masse non annulaire pratiquement pleine (44) de matériau isolant à l'intérieur du vide de la seconds couche (39); et
on forme le second noeud (46) en contact avec le matériau électriquement conducteur (36) de la première couche.

2. Le procédé de la revendication 1, dans lequel le second noeud (46) est en contact avec la masse non annulaire pratiquement pleine (44).

3. Le procédé de la revendication 1 ou de la revendication 2, dans lequel le second noeud (46) est constitué par un contact de conducteur de bit, et dans lequel le contact de conducteur de bit est en contact avec la seconde couche de matériau électriquement conducteur.

4. Le procédé de la revendication 1, dans lequel le premier noeud est une zone active et le second noeud est un contact de conducteur de bit, comprenant les étapes suivantes :
on forme une couche de matériau électriquement isolant (18) sur la zone active;
on forme une ouverture de prise de contact (32, 34) dans la couche de matériau isolant, en relation avec la zone active;
on forme la première couche (36) de matériau électriquement conducteur à l'intérieur de l'ouverture de prise de contact;
on forme la couche diélectrique (38) sur la première couche pour définir la cuvette de couche diélectrique à l'intérieur de l'ouverture de prise de contact;
on forme la seconde couche (40) de matériau électriquement conducteur à l'intérieur du vide de la couche diélectrique, pour définir le vide de la seconde couche à l'intérieur de l'ouverture de prise de contact; et
on forme un conducteur de bit (46) ayant un motif déterminé, en contact électrique par l'intermédiaire du contact de conducteur de bit avec le matériau électriquement conducteur de la première couche, à l'intérieur de l'ouverture de prise de contact.

5. Le procédé de la revendication 4, comprenant en outre l'attaque d'aplanissement de la première couche de matériau conducteur, en direction descendante, au moins jusqu'à la surface supérieure (31) de la couche de matériau isolant.

6. Le procédé de la revendication 1, dans lequel le premier noeud est une région active et le second noeud est un contact de conducteur de bit, comprenant en outre les étapes suivantes :
on forme un réseau de conducteurs de mot (12, 14, 16) pratiquement isolés électriquement, sur la surface supérieure d'une tranche de semiconducteur;
on forme des zones actives autour des conducteurs de mot pour définir un réseau de transistors à effet de champ de cellules de mémoire, les zones actives étant définies par une première région active pour la connexion électrique à un condensateur de cellule de mémoire, et une seconde région active pour la connexion électrique à un conducteur de bit, la seconde région de zone active étant le premier noeud;
on forme une couche de matériau électriquement isolant (18) sur les conducteurs de mot et les régions actives, la couche de matériau isolant ayant une surface supérieure qui est au-dessus des conducteurs de mot;
on forme des premières (32) et secondes (34) ouvertures de prise de contact respectives à travers la couche de matériau isolant, jusqu'aux premières (26) et secondes (24) zones actives respectives;
on forme une première couche de matériau électriquement conducteur (36) sur la couche de matériau isolant et à l'intérieur des premières et secondes ouvertures de prise de contact, qui est connectée électriquement aux premières et seconde régions actives respectives, la première couche étant formée avec une épaisseur qui ne remplit pas complètement les premières et secondes ouvertures de prise de contact, en laissant ainsi des premiers vides ouverts vers l'extérieur à l'intérieur des premières et secondes ouvertures de prise de contact;
on forme une couche diélectrique sur la première couche et à l'intérieur des vides de la première couche des premières et secondes ouvertures de prise de contact, la couche diélectrique étant formée avec une épaisseur qui ne remplit pas complètement les premiers vides, pour laisser ainsi des cuvettes de couche diélectrique ouvertes vers l'extérieur à l'intérieur des première et seconde ouvertures de prise de contact,
on forme une seconde couche (40) de matériau conducteur de l'électricité à l'intérieur des vides de couche diélectrique des premières et secondes ouvertures de prise de contact;
on isole électriquement tout le matériau électriquement conducteur à l'intérieur des premières ouvertures de prise de contact, vis-à-vis de tout le matériau électriquement conducteur à l'intérieur des secondes ouvertures de prise de contact;
on forme une couche isolante de conducteur de bit (44) du côté extérieur de la seconde couche de matériau électriquement conducteur;
on définit une ouverture de prise de contact de bit (45) à travers la couche isolante de conducteur de bit (44) pour exposer à l'extérieur le matériau électriquement conducteur de la première couche, à l'intérieur des secondes ouvertures de prise de contact;
on forme le contact de conducteur de bit dans l'ouverture de prise de contact de bit; et
on forme un conducteur de bit (46) ayant un motif déterminé, en contact électrique, par l'intermédiaire de l'ouverture de prise de contact de bit, avec le matériau électriquement conducteur de la première couche exposé à l'extérieur, dans les secondes ouvertures de prise de contact.

7. Le procédé de la revendication 6, dans lequel l'étape d'isolation électrique comprend une attaque d'aplanissement de la première couche de matériau conducteur, en direction descendante, au moins jusqu'à la surface supérieure de la couche de matériau isolant, pour isoler la première couche de matériau conducteur à l'intérieur des premières ouvertures de prise de contact vis-à-vis du matériau conducteur à l'intérieur des secondes ouvertures de prise de contact, une telle attaque d'aplanissement étant effectuée avant l'étape de formation de la couche diélectrique de condensateur.

8. Le procédé de la revendication 1, dans lequel le premier noeud est une région active (24) et le second noeud est un contact de conducteur de bit, comprenant en outre les étapes suivantes :
on forme un réseau de conducteurs de mot (12, 14, 16), pratiquement isolés électriquement, sur la surface supérieure d'une tranche de semiconducteur;
on forme des zones actives (24, 26) autour des conducteurs de mot, les zones actives étant définies par une première région active (26) et une seconde région active (24), la seconde région active (24) étant le premier noeud;
on forme une couche (18) de matériau électriquement isolant sur les conducteurs de mot et les régions actives;
on forme des premières (32) et secondes (34) ouvertures de prise de contact respectives à travers la couche de matériau isolant, jusqu'aux premières et secondes régions actives respectives;
on forme la première couche (36) de matériau électriquement conducteur sur la couche de matériau isolant et à l'intérieur des premières et secondes ouvertures de prise de contact pour qu'elle soit connectée électriquement aux premières et seconde régions actives respectives, la première couche étant formée avec une épaisseur qui ne remplit pas complètement les premières et secondes ouvertures de contact, la première couche laissant des premiers vides de couche ouverts vers l'extérieur dans les premières et secondes ouvertures de prise de contact;
on forme la couche diélectrique sur la première couche et à l'intérieur des premiers vides des premières et secondes ouvertures de prise de contact, la couche diélectrique étant formée avec une épaisseur qui ne remplit pas complètement les premiers vides de couche, pour laisser ainsi des cuvettes de couche diélectrique ouvertes vers l'extérieur dans les premières et secondes ouvertures de contact;
on forme le second matériau électriquement conducteur à l'intérieur des cuvettes de couche diélectrique des premières et secondes ouvertures de prise de contact;
et on forme un conducteur de bit, ayant un motif déterminé, en communication électrique par l'intermédiaire du contact de conducteur de bit avec le matériau conducteur de la première couche, dans les secondes ouvertures de prise de contact.

9. Le procédé de la revendication 8, comprenant en outre l'isolation électrique de tout le matériau électriquement conducteur à l'intérieur des premières ouvertures de contact, vis-à-vis de tout le matériau électriquement conducteur à l'intérieur des secondes ouvertures de prise de contact.

10. Le procédé de la revendication 8, comprenant en outre les étapes suivantes :
on isole électriquement tout le matériau électriquement conducteur à l'intérieur des premières ouvertures de prise de contact vis-à-vis de tout le matériau électriquement conducteur à l'intérieur des secondes ouvertures de prise de contact;
on forme une couche isolante de conducteur de bit du côté extérieur de la seconde couche de matériau électriquement conducteur; et
on définit une ouverture de prise de contact de bit à travers la couche isolante de conducteur de bit, pour exposer à l'extérieur le matériau électriquement conducteur de la première couche, à l'intérieur des secondes ouvertures de prise de contact.

11. Un circuit intégré comprenant un bouchon d'interconnexion électriquement conducteur, établissant une connexion électrique entre au moins deux noeuds de circuit à des niveaux différents, le circuit intégré comprenant :
un premier noeud (24) de niveau inférieur;
un second noeud (46) de niveau supérieur; et
un bouchon d'interconnexion comprenant : une cuvette extérieure électriquement conductrice (36) en contact électrique avec les premier et second noeuds;
une cuvette électriquement isolante (38) à l'intérieur de la cuvette extérieure électriquement conductrice;
**caractérisé par** :
une cuvette électriquement conductrice intérieure (40) à l'intérieur de la cuvette électriquement isolante; et
une masse non annulaire pratiquement pleine (44) de matériau isolant à l'intérieur de la cuvette électriquement conductrice intérieure.
